# EUROPÄISCHE PATENTSCHRIFT

(11) **EP 1 607 621 B1**
(45) Veröffentlichungstag und Bekanntmachung des Hinweises auf die Patenterteilung: **08.09.2010**
(21) Anmeldenummer: 05105301.5
(22) Anmeldetag: 16.06.2005
(51) Int. Cl.: F02M 61/16, F02M 59/46, F02M 51/06

(54) **Piezoelektrischer Stellantrieb für einen Kraftstoffinjektor einer Brennkraftmaschine sowie Verwendung hierfür**
Piezoelectric drive for a fuel injector of a combustion engine and its use
Mécanisme de commande piézoélectrique pour un injecteur de carburant d'un moteur à combustion interne et procédé

(30) Priorität: 17.06.2004 DE 102004029363
(43) Veröffentlichungstag der Anmeldung: 21.12.2005
(73) Patentinhaber: Continental Automotive GmbH, 30165 Hannover (DE)
(72) Erfinder: Weisse, Manfred, 90489, Nürnberg (DE); Fruth, Werner, 92272, Freudenberg (DE); Unruh, Marcus, 93197, Zeitlarn (DE)

(56) Entgegenhaltungen:
- EP-A- 0 745 766
- EP-A- 1 256 711
- WO-A-03/052260
- DE-A1- 10 130 857
- DE-A1- 19 538 791
- DE-C1- 19 858 085
- US-A- 4 437 644
- US-B1- 6 422 482
- PATENT ABSTRACTS OF JAPAN Bd. 1998, Nr. 05, 30. April 1998 (1998-04-30) & JP 10 009084 A (NISSAN MOTOR CO LTD), 13. Januar 1998 (1998-01-13)

## Beschreibung

Die vorliegende Erfindung betrifft einen Stellantrieb für einen Kraftstoffinjektor einer Brennkraftmaschine nach dem Oberbegriff des Anspruchs 1 sowie die Verwendung eines derartigen Stellantriebs.

Ein derartiger Stellantrieb ist beispielsweise aus der DE 198 58 085 C1 oder der EP 1 256 711 A bekannt und umfasst einen länglichen piezoelektrischen Aktor, dessen bei Ansteuerung resultierende Längenänderung in Axialrichtung auf ein hydraulisches Servoventil eines Kraftstoffinjektors übertragen wird. Hierzu steht eine Bodenplatte des Piezoaktors über einen Hebelübersetzer mit einem axial geführten Ventilkolben des Servoventils in Wirkverbindung. Die vom Piezoaktor mittels des Hebelübersetzers auf den Ventilkolben übertragene Bewegung wird im Kraftstoffinjektor zum Öffnen und Schließen eines Kraftstoff-Einspritzventils genutzt.

Die Verwendung eines derartigen Stellantriebs in einer Umgebung mit sich verändernder Temperatur ist insofern problematisch, als es hierbei auf Grund der thermischen Ausdehnung der verwendeten Werkstoffe zu Längenänderungen kommt, die sich in unerwünschter Weise auf die Funktion und Ansteuercharakteristik des Stellantriebs und somit der damit gesteuerten Komponente (z. B. Einspritzventil) auswirken können. Besonders nachteilig ist hierbei die temperaturabhängige Änderung der axialen Lageverhältnisse im Bereich der Wirkverbindung.

Bei bekannten Injektorkonstruktionen wird diese Temperaturabhängigkeit oftmals insofern berücksichtigt, als ein mehr oder weniger großer axialer Spalt im Wirkungsweg vom Aktor zu einem Ventilkörper vorgesehen wird, der als Toleranzbereich für eine unerwünschte Abweichung und/oder Änderung der axialen Dimensionen dient. Doch auch bei Vorsehen eines solchen Toleranzspalts wirken sich Temperaturänderungen nachteilig aus, da die Größe des Spalts (Leerhub) verändert wird.

Aus der DE 195 38 791 C2 ist ein Piezosteuerventil für Kraftstoffeinspritzanlagen bekannt, bei welchem der Piezoaktor in einem als zweiteilige Hülse ausgebildeten Ventilgehäuse angeordnet ist, dessen Hülsenteile koaxial zueinander liegen und aus verschiedenen Werkstoffen mit unterschiedlichen Wärmeausdehnungskoeffizienten bestehen. In einem Ausführungsbeispiel ist ein unterer Hülsenteil aus üblichem Stahl gefertigt, während ein oberer Hülsenteil aus Invar hergestellt ist. Damit ist es möglich, eine annähernd gleiche Längenausdehnung des im Wesentlichen aus Keramik bestehenden Piezoaktors einerseits und des zweiteiligen Ventilgehäuses andererseits zu erhalten, so dass die Summe der Wärmedehnungen dieser Hülsenteile der Wärmedehnung des Piezoaktors entspricht. Vorteilhaft können damit temperaturabhängige Änderungen des axialen Abstands zwischen einem Aktorboden und einem in Wirkverbindung damit stehenden Verschlussstück relativ klein gehalten werden. Nachteilig ist bei dieser Lösung jedoch die mangelnde Flexibilität der Temperaturkompensation, da die beschriebene Werkstoffkombination nur eine bestimmte Abhängigkeit zwischen Temperatur und Längenänderung der Piezokeramik kompensieren kann. Ferner ergeben sich hohe Materialkosten und/oder Bearbeitungskosten für das zweiteilige, wenigstens ein "exotisches" Material enthaltende Ventilgehäuse im Vergleich zu einem aus Stahl gefertigten Gehäuse.

Aus der DE 101 30 857 A1 ist ein elektronischer Kompensator für einen piezoelektrischen Stellantrieb bekannt. Zur Kompensation der Wärmeausdehnung bei unterschiedlichen Betriebsbedingungen wird die Größe eines axialen Spalts im Bereich einer Wirkverbindung zwischen einem als Kappe ausgebildeten Aktorboden und einem als Schaft ausgebildeten Stellglied mittels einer Abtastspule gemessen und über einen Regelkreis kompensiert. Diese Kompensation erfolgt durch Ansteuerung eines hierfür vorgesehenen Satzes von mehreren Sätzen von piezoelektrischen Elementen eines Piezostapels. Nachteilig ist jedoch der zusätzliche Aufwand, der für die Erfassung, Auswertung und Regelung der Spaltgröße erforderlich ist.

Es ist eine Aufgabe der vorliegenden Erfindung, bei einem Stellantrieb der eingangs erwähnten Art eine kostengünstige und einfache Temperaturkompensation zur ermöglichen.

Diese Aufgabe wird gelöst durch die Merkmale der unabhängigen Ansprüche. Die abhängigen Ansprüche betreffen vorteilhafte Weiterbildungen der Erfindung.

Bei dem erfindungsgemäßen Stellantrieb ist in der Gehäuseanordnung wenigstens eine Thermobimetalleinheit angeordnet, mittels welcher eine temperaturabhängige Änderung der axialen Lageverhältnisse im Bereich der Wirkverbindung, z. B. eine Änderung des axialen Abstands zwischen dem Gehäuseboden und dem Stellglied, wenigstens teilweise kompensiert werden kann.

Der Begriff "Thermobimetalleinheit" soll hierbei jede Einheit umfassend einen Verbund aus zwei entlang einer im Wesentlichen orthogonal zur Axialrichtung ausgedehnten Grenzfläche miteinander verbundener Werkstoffe (bevorzugt metallische Werkstoffe) mit unterschiedlichem Wärmeausdehnungskoeffizienten bezeichnen, bei welchem die unterschiedliche Wärmeausdehnung dieser Werkstoffe zu einer Krümmungsänderung der Grenzfläche und dadurch zu einer Änderung der axialen Dimension der Einheit führt.

Die im Innenraum der ein- oder mehrteilig ausgeführten Gehäuseanordnung vorgesehene Thermobimetalleinheit kann beispielsweise insgesamt die Form eines Streifens oder einer Platte besitzen, wobei die Grenzfläche bei einer bestimmten im Betrieb des Stellantriebs zu erwartenden Temperatur eben oder auch über den gesamten zu erwartenden Temperaturbereich gekrümmt vorgesehen sein kann.

Es können eine oder mehrere solcher Thermobimetalleinheiten eingebaut sein, die auf Grund ihrer inhärent vergleichsweise großen axialen Längenänderung sehr wirksam temperaturabhängige Dimensionsänderungen der übrigen Bauteile in Axialrichtung kompensieren können. Diese Kompensation kann somit in kostengünstiger und einfacher Weise realisiert werden.

Der erfindungsgemäße Stellantrieb findet eine vorteilhafte Verwendung z. B. für einen Kraftstoffinjektor eines Common-Rail-Dieseleinspritzsystems, da die beim Betrieb derartiger Systeme auftretenden großen Temperaturschwankungen (typisch z. B. -40°C bis +160°C) durch das oder die Thermobimetalleinheiten gut gehandhabt werden können.

Bei Installationsumgebungen, in denen die Wirkverbindung zwischen Aktorboden und Stellglied einen gewissen Leerhub des Piezoaktors vorsieht, der z. B. durch einen axialen Spalt zwischen Aktorboden und Stellglied oder zwischen anderen Komponenten im Wirkungsweg zwischen Piezoaktor und zu verstellender Einrichtung realisiert wird, ist es vorteilhaft möglich, diesen Leerhub über den gesamten in der Praxis genutzten Temperaturbereich wenigstens annähernd konstant zu halten. Ein weiterer Vorteil des erfindungsgemäßen Stellantriebs besteht darin, dass die Anzahl, Anordnung und Gestaltung der Thermobimetalleinheiten flexibel an die Konstruktion und Temperaturcharakteristik der übrigen Stellantriebkomponenten angepasst werden können. Somit ist es insbesondere möglich, bei Änderungen im Aufbau des Piezoaktors von Ausführung zu Ausführung, die ein geändertes thermisches Ausdehnungsverhalten mit sich bringen können, mit vergleichsweise geringem konstruktiven Aufwand die gewünschte Temperaturkompensation anzupassen. Eine solche Anpassung des oder der Thermobimetalleinheiten kann beispielsweise erfolgen durch geringfügige Änderungen bei der Wahl der beiden Werkstoffe, der Formgebung (insbesondere Dicke) dieser Werkstoffe und der bei Installation der Thermobimetalleinheit vorgesehenen Krümmung der Grenzfläche zwischen diesen Werkstoffen.

Wenngleich die aus dem Stand der Technik bekannte Verwendung "exotischer Materialien" für Teile oder die ganze Gehäuseanordnung auch in Kombination mit der Erfindung zur Temperaturkompensation genutzt werden kann, so besteht ein wesentlicher Vorteil der Erfindung darin, dass die damit verbundenen hohen Material- und Bearbeitungskosten gerade vermieden werden können, indem die Gehäuseanordnung wenigstens teilweise, größtenteils oder sogar ganz aus einem kostengünstigen Material wie Stahl hergestellt wird. Auch die prinzipiell denkbare Verwendung eines hinsichtlich des thermischen Ausdehnungskoeffizienten speziell gewählten und mithin eher teuren und unter Umständen aufwändig zu bearbeitenden Stellglieds, z. B. des Ventilkolbens eines hydraulischen Ventils aus Cermet, ist entbehrlich.

Bei dem erfindungsgemäßen Stellantrieb ergibt sich eine stark vergrößerte Freiheit in der Werkstoffauswahl der Bauteile des Stellantriebs sowie damit verbundener Komponenten, was vor allem hinsichtlich des Aspekts der Kosteneinsparung sowie des Aspekts der Flexibilität bei der Konstruktion interessant ist.

In einer bevorzugten Ausführungsform umfasst die Thermobimetalleinheit eine gewölbte Thermobimetallplatte, deren konvexe Stirnseite an einer weiteren, ebenen Platte anliegt, um diese bei einer Temperaturänderung in Axialrichtung zu verschieben. Die Anlage der ebenen Platte an der konvexen Wölbung der Thermobimetallplatte gewährleistet eine radial gut definierte Lage des Anlagepunktes. Darüber hinaus ergibt sich eine in der Praxis zumeist vorteilhafte hohe elastische Steifigkeit der gekrümmten Thermobimetallplatte im Vergleich zu einer ebenen Thermobimetallplatte.

Im Rahmen der Erfindung gibt es eine Fülle von Möglichkeiten, eines oder mehrere Thermobimetalleinheiten in den Stellantrieb zu integrieren. In einer bevorzugten Ausführungsform ist vorgesehen, dass der Gehäusekopf und/oder der Aktorboden und/oder das Stellglied als Thermobimetalleinheit ausgebildet ist oder eine Thermobimetalleinheit enthält. Vorteilhaft besitzen die betreffenden Komponenten dann neben ihrer herkömmlichen Funktion eine zusätzliche Funktion zur Temperaturkompensation.

Bevorzugt ist die Thermobimetalleinheit in der Gehäuseanordnung derart angeordnet, dass bei Temperaturänderung eine axiale Verlagerung des Piezoaktors gegenüber der Gehäuseanordnung oder eine axiale Verlagerung des Stellglieds gegenüber dem Aktorboden bewirkt wird.

Die mittels der Thermobimetalleinheit bewirkbare große und individuell an die Gesamtkonstruktion anpassbare Längenänderung in Axialrichtung ermöglicht es, bei der Konstruktion der übrigen Stellantriebskomponenten deren thermische Eigenschaften weitgehend außer Acht zu lassen. Insbesondere ist es möglich, die in der Regel materialintensive Gehäuseanordnung auch ganz aus Stahl herzustellen.

Eine fertigungstechnisch einfache Festlegung des Gehäusekopfes am ersten Ende der Gehäuseanordnung lässt sich z. B. durch ein Verschweißen eines Abschnitts des Gehäusekopfes mit der Gehäuseanordnung erreichen.

In einer Ausführungsform ist vorgesehen, dass der Gehäusekopf plattenförmig ausgebildet ist und/oder der Aktorboden einen dem Piezoaktor zugewandten, plattenförmig ausgebildeten Abschnitt aufweist. Ein mittlerer Bereich des Aktorbodens kann auf der dem Piezoaktor entgegengesetzten Seite eine Erhebung aufweisen, welche in Wirkverbindung mit dem zu verstellenden Stellglied steht.

In einer bevorzugten Ausführungsform ist der Piezoaktor als ein in Axialrichtung langgestreckter Piezoelementstapel ausgebildet. Damit lässt sich vorteilhaft eine vergleichsweise große axiale Längenänderung bei der Ansteuerung des Aktors bewirken. Die andererseits mit zunehmender Größe des Piezoaktors in Axialrichtung tendenziell zunehmenden thermisch bedingten Ausdehnungsunterschiede in Axialrichtung können hierbei durch das oder die effizient wirkenden Thermobimetalleinheiten kompensiert werden.

Der Piezoaktor kann in einer sich über die gesamte axiale Länge desselben erstreckenden Rohrfeder angeordnet sein, deren Enden im Bereich des Gehäusekopfes und am Aktorboden festgelegt sind und welche den Piezoaktor in Axialrichtung auf Druck vorbelastet. Dies trägt dazu bei, die dynamischen Belastungen der Piezokeramik zu mindern und möglichst gut definierte Lageverhältnisse der Stellantriebkomponenten in Axialrichtung zu gewährleisten.

In kostengünstiger Weise kann außer für die Gehäuseanordnung auch für das Stellglied eine Herstellung größtenteils aus Stahl vorgesehen sein. Das Stellglied kann beispielsweise als Ventilbetätigungskolben eines Hydraulikventils ausgebildet sein, welches sich an dem zweiten Ende der Gehäuseanordnung befindet oder sich daran anschließt.

Die Erfindung wird nachfolgend anhand eines Ausführungsbeispiels mit Bezug auf die beigefügten Zeichnungen näher beschrieben. Es stellen dar:
- Fig. 1: einen Axiallängsschnitt eines Stellantriebs nach dem Stand der Technik,
- Fig. 2: eine Schnittansicht (Fig. 2 oben) sowie eine Draufsicht (Fig. 2 unten) einer in dem Stellantrieb von Fig. 1 verwendeten Kopfplatte,
- Fig. 3: einen Axiallängsschnitt eines Stellantriebs gemäß eines ersten Ausführungsbeispiels der Erfindung, und
- Fig. 4: eine Schnittansicht (Fig. 4 oben) eines in dem Stellantrieb von Fig. 3 verwendeten Gehäusekopfes sowie Draufsichten (Fig. 4 unten) der drei Gehäusekopfkomponenten.

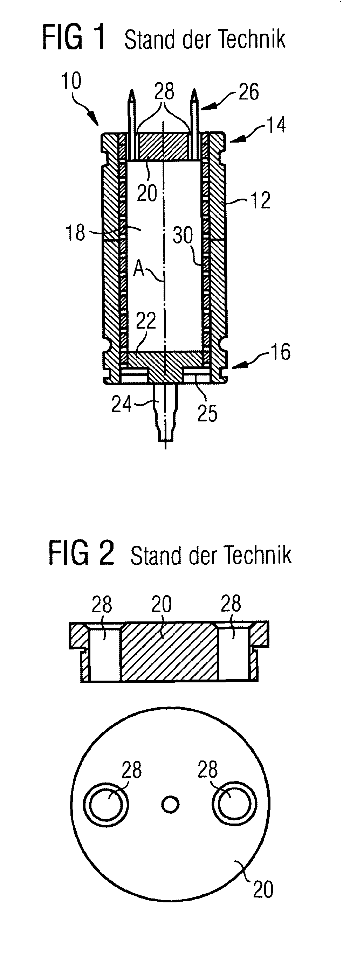

Die Fig. 1 und 2 veranschaulichen den Aufbau eines herkömmlichen Stellantriebs 10, der eine obere Baugruppe einer Kraftstoffinjektoreinheit bildet, die in ihrem unteren Bereich ein (nicht dargestelltes) Kraftstoffeinspritzventil aufweist. Der Stellantrieb 10 dient in nachfolgend beschriebenen Weise zur gesteuerten Betätigung dieses Einspritzventils.

Der Stellantrieb 10 umfasst in an sich bekannter Weise ein hülsenartiges, hier im Wesentlichen hohlzylindrisches Gehäuse 12 mit einer Längsachse A, die von einem oberen Ende 14 des Gehäuses zu einem unteren Ende 16 des Gehäuses verläuft, einen in dem Gehäuse 12 angeordneten Piezoaktor 18, der für eine Längenänderung in Axialrichtung ansteuerbar ist, einen am oberen Ende 14 des Gehäuses 12 angeschweißten Gehäusekopf 20, an welchem sich das obere Ende des Piezoaktors 18 in Axialrichtung abstützt, einen in Axialrichtung bewegbar in dem Gehäuse 12 geführten Aktorboden 22, an welchem sich das untere Ende des Piezoaktors 18 in Axialrichtung abstützt, und einen in Axialrichtung bewegbaren Ventilkolben 24 des Einspritzventils, welcher in Wirkverbindung mit dem Aktorboden 22 steht, um eine Axiallängenänderung des Piezoaktors 18 auf den Ventilkolben 24 zu übertragen.

Diese Wirkverbindung ist durch direkte Anlage eines nach unten abstehenden Abschnitts des Aktorbodens 22 an einer oberen Anlagefläche des Ventilkolbens 24 realisiert. Um den Gehäuseinnenabschnitt, welcher den Piezoaktor 18 enthält, von dem Raum unterhalb des Aktorbodens 22 abzudichten, ist ein Membranring 25 vorgesehen, dessen Außenumfang mit der Gehäuseinnenseite verschweißt ist und dessen Innenumfang mit dem Außenumfang des nach unten abstehenden Aktorbodenabschnitts verschweißt ist. Dieser Membranring 25 ist vergleichsweise dünn, so dass dieser sich bei Ansteuerung des Piezoaktors 18 elastisch verformen kann.

Die Wirkverbindung kann jedoch auch in anderer Weise realisiert sein, z. B. durch einen Hebelübersetzer wie in der eingangs bereits erwähnten DE 198 58 085 C1 beschrieben.

Auch könnte der Membranring 25 alternativ als eine zwischen Aktorboden 22 und Ventilkolben 24 durchgehende und lediglich an der Gehäuseinnenwandung verschweißte Scheibe vorgesehen sein.

Bei dem nicht dargestellten Einspritzventil kann es sich z. B. um ein Servoeinspritzventil handeln, welches mittels des Piezoaktors 18 betätigbar ist, wobei zur Initiierung eines Einspritzvorganges eine Druckverringerung in einem Steuerraum bewirkt wird, die wiederum eine Bewegung eines Einspritzventil-Düsenkörpers (Düsennadel) in Richtung einer Öffnung einer Einspritzpassage hervorruft, die zwischen einem Düsenraum des Einspritzventils und einer Brennkammer einer Brennkraftmaschine vorgesehen ist.

Ein wesentlicher Vorteil der Verwendung eines mittels eines piezoelektrischen Aktors betätigten Servoeinspritzventils ist es, dass mit einem vergleichsweise kleinen Hub (im µm-Bereich) des Piezoaktors ein davon unabhängiger, in der Regel um ein Vielfaches größerer Hub des Düsenkörpers erzielt werden kann (Hydraulische Hubübersetzung). Zudem ergibt sich hierbei der Vorteil, dass die Bewegung des Düsenkörpers zum Öffnen und Schließen der Einspritzpassage durch den Druck des Kraftstoffs getrieben wird, der zu Zwecken der Einspritzung in die Brennkammer ohnehin unter vergleichsweise großem Druck stehend im Bereich des Einspritzventils bereitsteht. Für die Ansteuerung des Einspritzventils genügt daher ein Aktor mit vergleichsweise geringem Hub und vergleichsweise geringer Aktorkraft.

Der Piezoaktor 18 des Stellantriebs 10 weist einen Stapel aufeinander liegender Piezoelemente auf, die beim Anlegen einer elektrischen Spannung über eine Kontaktstiftanordnung 26 rasch seine axiale Ausdehnung um ein von der Spannung abhängiges Ausmaß verändert. Hierfür geeignete piezoelektrische Keramiken sind in großer Vielfalt bekannt, beispielsweise als Bleizirkonat-Titanat-Keramiken.

Problematisch ist im Betrieb der Kraftstoffinjektoreinheit, dass es bei einer Temperaturänderung der Installationsumgebung zu thermischen Formänderungen der einzelnen Komponenten kommt. Diese Formänderungen können auf Grund der Verschiedenartigkeit der verwendeten Materialien die Leistungseigenschaften und die Ansteuercharakteristik des Stellantriebs 10 bzw. des damit betätigten Einspritzventils temperaturabhängig verändern.

Diese nachteilige Temperaturabhängigkeit besitzt in der Praxis ein großes Ausmaß, da die für den Piezoeffekt geeigneten Keramikmaterialien einen relativ geringen thermischen Ausdehnungskoeffizienten besitzen, wohingegen die üblicherweise aus metallischen Werkstoffen(z. B. Stahl) gefertigten anderen Komponenten im Vergleich dazu einen großen (stets positiven) thermischen Ausdehnungskoeffizienten besitzen. Bei dem dargestellten Stellantrieb 10 wirken Temperaturänderungen insbesondere im Sinne einer axialen Verschiebung der Positionen des Aktorbodens 22 und/oder des Ventilkolbens 24. Darüber hinaus tendiert der axiale Abstand zwischen Gehäuseboden 22 und Ventilkolben 24 bei Temperaturänderungen dazu, sich zu verändern.

Fig. 2 zeigt den einteilig als Stahlplatte ausgebildeten Gehäusekopf 20 mit Durchgangsöffnungen 28 zum Durchtritt von zwei Kontaktstiften der Kontaktstiftanordnung 26. In der in Fig. 1 dargestellten Einbausituation ist dieser Gehäusekopf 20 am Umfang sowohl mit dem oberen Gehäuseende 14 als auch mit dem oberen Ende einer Rohrfeder 30 verschweißt, deren unteres Ende am Umfang des Aktorbodens 22 angeschweißt ist und welche die Piezokeramik auf Druck in Axialrichtung (Druckkraft ca. 1x10³ N) vorbelastet. Diese Vorbelastung verringert die während des Betriebs auftretenden dynamischen Belastungen der extrem zugempfindlichen Piezokeramik.

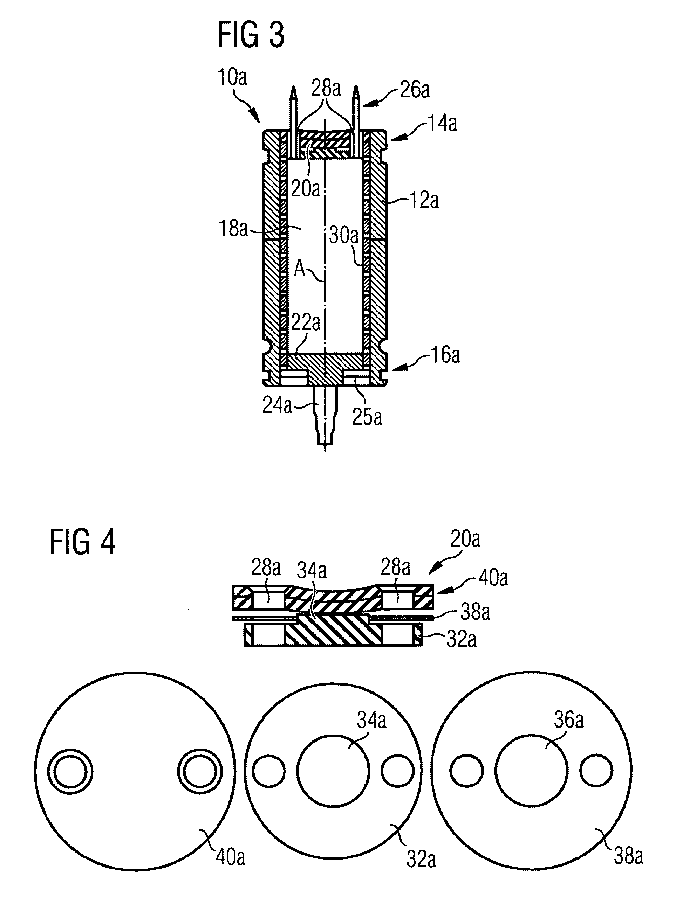

Das nachteilige Temperaturverhalten des bekannten Stellantriebs kann durch Integration eines oder mehrerer Thermobimetalleinheiten beseitigt werden. Ein solcher erfindungsgemäßer Stellantrieb wird nun mit Bezug auf die Fig. 3 und 4 beschrieben. Bei dieser nachfolgenden Beschreibung von Ausführungen der Erfindung werden für analoge Komponenten die gleichen Bezugszahlen verwendet, jeweils ergänzt durch den kleinen Buchstaben "a". Dabei wird im Wesentlichen nur auf die Unterschiede zu dem mit Bezug auf die Fig. 1 und 2 bereits beschriebenen Stellantrieb eingegangen und im Übrigen hiermit ausdrücklich auf die obige Beschreibung zu den Fig. 1 und 2 verwiesen.

Fig. 3 zeigt einen Stellantrieb 10a, bei welchem ein Gehäusekopf 20a als Thermobimetalleinheit zur Kompensation einer temperaturabhängigen Änderung der axialen Lageverhältnisse im Bereich der Wirkverbindung ausgebildet ist. Die damit realisierte Temperaturkompensation beruht auf einer axialen Verlagerung des Piezoaktors 18a gegenüber dem Gehäuse 12a.

Der Aufbau dieses modifizierten Gehäusekopfes 20a ist detaillierter in Fig. 4 gezeigt. Der Gehäusekopf 20a ist insgesamt plattenförmig ausgebildet und besteht aus drei Teilen. Ein unterer Teil wird von einer Stahlplatte 32a gebildet, welche in ihrem Zentrum eine Erhebung 34a aufweist. Diese Erhebung 34a durchgreift eine zentrale Öffnung 36a eines als Membranring 38a (aus Stahl) ausgebildeten mittleren Teils. Ein oberer Teil ist schließlich von einer gewölbten Thermobimetallplatte 40a gebildet, deren nach unten weisende konvexe Stirnseite an der Erhebung 34a anliegt. Bei einer Temperaturänderung wird somit die als obere Abstützung oder Befestigung für den Piezoaktor 18a dienende Platte 32a in Axialrichtung verschoben, um eine temperaturbedingte Änderung der axialen Lageverhältnisse im Bereich der Wirkverbindung zwischen dem Aktorboden 22a und dem Ventilkolben 24a zu kompensieren.

Die Platte 32a ist an ihrem Umfangsrand mit der Rohrfeder 30a verschweißt und überträgt die Vorspannkraft der Rohrfeder 30a auf den Keramikkörper des Piezoaktors 18a. Der Membranring 38a und die Thermobimetallplatte 40a sind an ihren äußeren Umfangsrändern mit dem oberen Gehäuseende 14a verschweißt.

Wenngleich abweichend vom dargestellten Ausführungsbeispiel sowohl der Membranring 38a als auch die untere Stahlplatte 32a prinzipiell weggelassen werden könnten, so erfüllen diese Komponenten bei der dargestellten Ausführung sehr vorteilhafte Funktionen. Die Platte 32a wirkt für eine Vergleichmäßigung und radiale Verteilung der zwischen dem Gehäusekopf 20a und dem Piezoaktor 18a wirkenden Axialkraft. In diesem Zusammenhang ist zu erwähnten, dass diese Funktion auch durch eine geeignet ausgebildete und an dem Rohrfederende abgestützte Deckschicht am oberen Ende des Piezoaktors 18a realisiert werden könnte. Der angeschweißte Membranring 38a lässt eine Bewegung der Stahlplatte 32a in axialer Richtung zu, fixiert jedoch deren Lage in radialer Richtung, wobei eine Führung der Stahlplatte 32a mittels der zentralen Öffnung 36a des Membranrings 38a realisiert wird.

Die als Verbund zweier metallischer Werkstoffe mit unterschiedlichen thermischen Ausdehnungskoeffizienten ausgebildete Thermobimetallplatte 40a besitzt in ihrem zentralen Bereich eine etwa kugelkalottenförmige Krümmung, welche einerseits eine möglichst konstante Lage des Berührungspunktes mit der unteren Scheibe 32a gewährleistet und andererseits die elastische Steifigkeit im Vergleich zu einer prinzipiell ebenso denkbaren ebenen Ausführung vorteilhaft erhöht.

Abweichend vom dargestellten Ausführungsbeispiel könnte alternativ oder zusätzlich auch ein anderer Einbauort für die Thermobimetalleinheit vorgesehen sein, beispielsweise unmittelbar über oder unter dem Aktorboden 22a.

Durch die Verwendung der Thermobimetalleinheit(en) kommt es zu einer stark vergrößerten Freiheit in der Werkstoffwahl der Komponenten des Stellantriebs sowie der damit betätigten Einrichtung. Somit kann für die besonders materialintensiven Bauteile wie das Gehäuse 12a ein vergleichsweise kostengünstiges Material wie Stahl verwendet werden. Betreffend die Materialwahl bei dem Stellantrieb 10a seien nachfolgend lediglich beispielhaft zwei Möglichkeiten erläutert.

Beispielsweise kann der Ventilkolben 24a aus kostengünstigem und einfach zu bearbeitendem Stahl (hoher thermischer Ausdehnungskoeffizient) und das Gehäuse 12a aus einer Eisen-NickelLegierung (sehr niedriger thermischer Ausdehnungskoeffizient) hergestellt sein. Bei dieser Materialkombination kommt es in der Regel zu einer Überkompensation der thermischen Längenänderungen, so dass die Bimetallplatte hier so einzubauen ist, dass deren konvexe Wölbung sich bei einer Temperaturerhöhung gegenüber dem Piezoaktor 18a zurückzieht. Da nur eine geringe Längenänderung kompensiert werden muss, sollte die Bimetallplatte 40a relativ dick ausgeführt sein (Die thermisch bedingte Ausbiegung eines Bimetallverbundes ist stark von der Dicke abhängig). Eine solche relativ dicke Ausführung bringt eine hohe elastische Steifigkeit in Axialrichtung mit sich.

Eine andere Möglichkeit besteht darin, sowohl den Ventilkolben 24a als auch das Gehäuse 12a aus Stahl zu fertigen. Die Bimetallplatte 40a ist hier (umgekehrt zum vorstehend beschriebenen Fall) derart gestaltet, dass deren Berührungspunkt mit der Stahlscheibe 32a sich bei Temperaturerhöhung zum Piezoaktor 18a hin verschiebt. Außerdem ist bei dieser Ausführung die Bimetallplatte 40a zweckmäßigerweise dünner ausgeführt, da hier fast die gesamte axiale thermische Längenänderung des Gehäuses 12a auszugleichen ist. Diese Materialauswahl bringt im Vergleich zu dem vorstehend erläutertem Fall einen weiteren Kostenvorteil auf Grund der Verwendung von Stahl für das Gehäuse 12a.

## Patentansprüche

1. Stellantrieb für einen Kraftstoffinjektor einer Brennkraftmaschine, umfassend
- eine hülsenförmige Gehäuseanordnung (12a) mit einer Axialrichtung (A), die sich zwischen einem ersten und einem zweiten Ende (14a, 16a) der Gehäuseanordnung erstreckt,
- einen in der Gehäuseanordnung (12a) angeordneten und für eine Längenänderung in Axialrichtung (A) ansteuerbaren Piezoaktor (18a),
- einen in Axialrichtung (A) festgelegten Gehäusekopf (20a) am ersten Ende (14a) der Gehäuseanordnung(12a), an welchem sich ein erstes Ende des Piezoaktors (18a) in Axialrichtung abstützt,
- einen in Axialrichtung (A) bewegbar in der Gehäuseanordnung (12a) geführten Aktorboden (22a), an welchem sich ein zweites Ende des Piezoaktors (18a) in Axialrichtung abstützt, und
**dadurch gekennzeichnet, dass** in der Gehäuseanordnung (12a) wenigstens eine Thermobimetalleinheit angeordnet ist, um eine temperaturabhängige Änderung der axialen Lageverhältnisse im Bereich der Wirkverbindung wenigstens teilweise zu kompensieren.

2. Stellantrieb nach Anspruch 1, wobei die Thermobimetalleinheit (40a) eine gewölbte Thermobimetallplatte umfasst, deren konvexe Stirnseite an einer weiteren, ebenen Platte (32a) anliegt, um diese bei einer Temperaturänderung in Axialrichtung (A) zu verschieben.

3. Stellantrieb nach einem der vorangehenden Ansprüche, wobei der Gehäusekopf (20a) als die Thermobimetalleinheit ausgebildet ist oder die Thermobimetalleinheit enthält.

4. Stellantrieb nach einem der vorangehenden Ansprüche, wobei der Aktorboden (22a) als die Thermobimetalleinheit ausgebildet ist oder die Thermobimetalleinheit enthält.

5. Stellantrieb nach einem der vorangehenden Ansprüche, wobei das Stellglied (24a) als die Thermobimetalleinheit ausgebildet ist oder die Thermobimetalleinheit enthält.

6. Stellantrieb nach einem der vorangehenden Ansprüche, wobei die Thermobimetalleinheit in der Gehäuseanordnung (12a) derart angeordnet ist, dass bei Temperaturänderung eine axiale Verlagerung des Piezoaktors (18a) gegenüber der Gehäuseanordnung (12a) bewirkt wird.

7. Stellantrieb nach einem der vorangehenden Ansprüche, wobei die Thermobimetalleinheit in der Gehäuseanordnung (12a) derart angeordnet ist, dass bei Temperaturänderung eine axiale Verlagerung des Stellglieds (24a) gegenüber dem Aktorboden (22a) bewirkt wird.

8. Stellantrieb nach einem der vorangehenden Ansprüche, wobei die Gehäuseanordnung (12a) wenigstens teilweise aus Stahl hergestellt ist.

9. Stellantrieb nach einem der vorangehenden Ansprüche, wobei ein Abschnitt des Gehäusekopfes (20a) mit der Gehäuseanordnung (12a) verschweißt ist.

10. Stellantrieb nach einem der vorangehenden Ansprüche, wobei der Gehäusekopf (20a) plattenförmig ausgebildet ist.

11. Stellantrieb nach einem der vorangehenden Ansprüche, wobei der Aktorboden (22a) einen dem Piezoaktor zugewandten, plattenförmig ausgebildeten Abschnitt aufweist.

12. Stellantrieb nach einem der vorangehenden Ansprüche, wobei der Piezoaktor (18a) ein in Axialrichtung langgestreckter Piezoelementstapel ist.

13. Stellantrieb nach einem der vorangehenden Ansprüche, wobei der Piezoaktor (18a) in einer sich über die gesamte axiale Länge desselben erstreckenden Rohrfeder (30a) angeordnet ist, deren Enden im Bereich des Gehäusekopfes (20a) und am Aktorboden (22a) festgelegt sind und welche den Piezoaktor in Axialrichtung auf Druck vorbelastet.

14. Stellantrieb nach einem der vorhergehenden Ansprüche, **dadurch gekennzeichnet**, ein in Axialrichtung (A) bewegbar geführtes Stellglied (24a), welches in Wirkverbindung mit dem Aktorboden (22a) steht, um eine Axiallängenänderung des Piezoaktors (18a) auf das Stellglied (24a) zu übertragen,

15. Stellantrieb nach einem der vorangehenden Ansprüche, wobei das Stellglied (24a) größtenteils aus Stahl hergestellt ist.

16. Stellantrieb nach einem der vorangehenden Ansprüche, wobei das Stellglied (24a) als Ventilbetätigungskolben eines Hydraulikventils ausgebildet ist.

17. Verwendung eines Stellantriebs (10a) nach einem der Ansprüche 1 bis 15 für einen Kraftstoffinjektor eines Common-Rail-Dieseleinspritzsystems.

## Claims

1. Drive for a fuel injector of a combustion engine, comprising
- a sleeve-type housing arrangement (12a) having an axial direction (A), which extends between a first and a second end (14a, 16a) of the housing arrangement,
- a piezoactuator (18a) which is arranged in the housing arrangement (12a) and which can be controlled for a change in length in the axial direction (A),
- a housing head (20a) defined in the axial direction (A) at the first end (14a) of the housing arrangement (12a), against which a first end of the piezoactuator (18a) rests in the axial direction,
- an actuator base (22a) which is moveably guided in the axial direction (A) in the housing arrangement (12a), against which actuator base a second end of the piezoactuator (18a) rests in the axial direction, and
**characterised in that**
at least one thermo-bimetal unit is arranged in the housing arrangement (12a) in order to at least partially compensate for a temperature-dependent change in the axial positional relationships in the region of the active connection.

2. Drive according to claim 1, with the thermo-bimetal unit (40a) including an arched thermo-bimetal plate, the convex front face of which rests against a further, planar plate (32a), in order to displace this in the axial direction (A) during a change in temperature.

3. Drive according to one of the preceding claims, with the housing head (20a) being embodied as the thermo-bimetal unit or containing the thermo-bimetal unit.

4. Drive according to one of the preceding claims, with the actuator base (22a) being embodied as the thermo-bimetal unit or containing the thermo-bimetal unit.

5. Drive according to one of the preceding claims, with the drive (24a) being embodied as the thermo-bimetal unit or containing the thermo-bimetal unit.

6. Drive according to one of the preceding claims, with the thermo-bimetal unit being arranged in the housing arrangement (12a) such that an axial displacement of the piezoactuator (18a) relative to the housing arrangement (12a) is effected in the event of a change in temperature.

7. Drive according to one of the preceding claims, with the thermo-bimetal unit being arranged in the housing arrangement (12a) such that an axial displacement of the drive (24a) relative to the actuator base (22a) is effected in the event of a change in temperature.

8. Drive according to one of the preceding claims, with the housing arrangement (12a) being made at least partly of steel.

9. Drive according to one of the preceding claims, with a section of the housing head (20a) being welded to the housing arrangement (12a).

10. Drive according to one of the preceding claims, with the housing head (20a) being embodied in the manner of a plate.

11. Drive according to one of the preceding claims, with the actuator base (22a) having a plate-shaped section facing the piezoactuator.

12. Drive according to one of the preceding claims, with the piezoactuator (18a) being a piezoelement stack which is elongated in the axial direction.

13. Drive according to one of the preceding claims, with the piezoactuator (18a) being arranged in a tubular spring (30a) extending over the entire axial length of the same, the ends of which are defined in the region of the housing head (20a) and on the actuator base (22a) and which prestresses the piezoactuator in the axial direction with pressure.

14. Drive according to one of the preceding claims, **characterized in that** a drive (24a) which is moveably guided in the axial direction (A), and which is actively connected to the actuator base (22a) in order to transfer an axial change in length of the piezoactuator (18a) to the drive (24a),

15. Drive according to one of the preceding claims, with the drive (24a) predominantly being made of steel.

16. Drive according to one of the preceding claims, with the drive (24a) being embodied as a valve actuating piston of a hydraulic valve.

17. Use of a drive (10a) according to one of claims 1 to 15 for a fuel injector of a common rail diesel injection system.

## Revendications

1. Mécanisme de commande pour un injecteur de carburant d'un moteur à combustion interne, comprenant :
- un aménagement de boîtier (12a) en forme de douille avec une direction axiale (A), qui s'étend entre une première extrémité et une seconde extrémité (14a, 16a) de l'aménagement de boîtier,
- un actionneur piézoélectrique (18a) disposé dans l'aménagement de boîtier (12a) et pouvant être commandé sur une variation de longueur dans la direction axiale (A),
- une tête de boîtier (20a) fixée dans la direction axiale (A) à la première extrémité (14a) de l'aménagement de boîtier (12a), sur laquelle tête s'appuie une première extrémité de l'actionneur piézoélectrique (18a) dans la direction axiale,
- un fond d'actionneur (22a) guidé en déplacement dans la direction axiale (A) dans l'aménagement de boîtier (12a), sur lequel fond s'appuie une seconde extrémité de l'actionneur piézoélectrique (18a) dans la direction axiale, et
**caractérisé en ce que** l'on agence dans l'aménagement de boîtier (12a) au moins une unité à bilame thermique pour compenser au moins en partie une variation dépendant de la température des rapports de position axiale dans la zone de coopération.

2. Mécanisme de commande selon la revendication 1, dans lequel l'unité à bilame thermique (40a) comprend une plaque à bilame thermique bombée, dont la face frontale convexe s'applique sur une autre plaque plane (32a) pour déplacer celle-ci dans la direction axiale (A) lors d'une variation de température.

3. Mécanisme de commande selon l'une quelconque des revendications précédentes, dans lequel la tête de boîtier (20a) se présente sous la forme d'une unité à bilame thermique ou contient l'unité à bilame thermique.

4. Mécanisme de commande selon l'une quelconque des revendications précédentes, dans lequel le fond d'actionneur (22a) se présente sous la forme d'une unité à bilame thermique ou contient l'unité à bilame thermique.

5. Mécanisme de commande selon l'une quelconque des revendications précédentes, dans lequel l'élément de commande (24a) se présente sous la forme d'une unité à bilame thermique ou contient l'unité à bilame thermique.

6. Mécanisme de commande selon l'une quelconque des revendications précédentes, dans lequel l'unité à bilame thermique est agencée dans l'aménagement de boîtier (12a) de manière à provoquer un déplacement axial de l'actionneur piézoélectrique (18a) vis-à-vis de l'aménagement de boîtier (12a) lors d'une variation de température.

7. Mécanisme de commande selon l'une quelconque des revendications précédentes, dans lequel l'unité à bilame thermique est agencée dans l'aménagement de boîtier (12a) de manière à provoquer un déplacement axial de l'élément de commande (24a) vis-à-vis du fond d'actionneur (22a) lors d'une variation de température.

8. Mécanisme de commande selon l'une quelconque des revendications précédentes, dans lequel l'aménagement de boîtier (12a) est fabriqué au moins en partie en acier.

9. Mécanisme de commande selon l'une quelconque des revendications précédentes, dans lequel une section de la tête de boîtier (20a) est soudée à l'aménagement de boîtier (12a).

10. Mécanisme de commande selon l'une quelconque des revendications précédentes, dans lequel la tête de boîtier (20a) est conformée en plaque.

11. Mécanisme de commande selon l'une quelconque des revendications précédentes, dans lequel le fond d'actionneur (22a) présente une section conformée en plaque tournée vers l'actionneur piézoélectrique.

12. Mécanisme de commande selon l'une quelconque des revendications précédentes, dans lequel l'actionneur piézoélectrique (18a) est une pile d'éléments piézoélectriques allongée dans la direction axiale.

13. Mécanisme de commande selon l'une quelconque des revendications précédentes, dans lequel l'actionneur piézoélectrique (18a) est agencé dans un tube-ressort (30a) s'étendant sur toute la longueur axiale de ce dernier, dont les extrémités sont fixées dans la zone de la tête de boîtier (20a) et sur le fond d'actionneur (22a) et qui précontraint en pression l'actionneur piézoélectrique dans la direction axiale.

14. Mécanisme de commande selon l'une quelconque des revendications précédentes, **caractérisé par** un élément de commande (24a) guidé en déplacement dans la direction axiale (A), qui est en coopération avec le fond d'actionneur (22a) pour transmettre une variation de longueur axiale de l'actionneur piézoélectrique (18a) à l'élément de commande (24a).

15. Mécanisme de commande selon l'une quelconque des revendications précédentes, dans lequel l'élément de commande (24a) est fabriqué en grande partie en acier.

16. Mécanisme de commande selon l'une quelconque des revendications précédentes, dans lequel l'élément de commande (24a) se présente sous la forme d'un piston d'actionnement d'une soupape hydraulique.

17. Utilisation d'un mécanisme de commande (10a) selon l'une quelconque des revendications 1 à 15 pour un injecteur de carburant d'un système d'injection de diesel de type Common Rail.
